# EUROPEAN PATENT APPLICATION

(11) **EP 4 528 395 A1**
(43) Date of publication of application: **26.03.2025**
(21) Application number: 23827412.0
(22) Date of filing: 08.06.2023
(51) Int. Cl.: G04G 17/06, G04G 17/04, G04G 17/08, G04G 21/04, H01Q 1/27, H05K 9/00, H05K 1/11, G04G 99/00, G06F 1/16, H01Q 1/24

(54) **WEARABLE ELECTRONIC DEVICE**

(30) Priority: 24.06.2022 KR 20220077771; 07.07.2022 KR 20220083879
(71) Applicant: Samsung Electronics Co., Ltd., Suwon-si, Gyeonggi-do 16677 (KR)
(72) Inventor: KIM, Hansol, Suwon-si Gyeonggi-do 16677 (KR); YUN, Heeyoung, Suwon-si Gyeonggi-do 16677 (KR)
(74) Representative: Gulde & Partner
(86) International application number: PCT/KR2023/007867
(87) International publication number: WO 2023/249292

(57) **Abstract**

A wearable electronic device may include a frame, a printed circuit board disposed within the frame and including at least one ground portion, and a connecting member. The connecting member may include an extension portion, a first portion extending from a first end of the extension portion and connected to the printed circuit board, a second portion extending from a second end of the extension portion and connected to a conductive region of the printed circuit board, and a conductive trace extending from the first portion to the second portion through the extension portion. The conductive trace may be electrically connected to the at least one ground portion through the conductive region of the printed circuit board.

## Description

### TECHNICAL FIELD

Embodiments disclosed herein relate to a wearable electronic device.

### BACKGROUND ART

Electronic devices may include an antenna for transmitting and receiving wireless signals. The antenna may include a housing of an electronic device as an antenna element. For example, the housing of the electronic device may be formed at least partially from metal. The antenna of the electronic device may include a metal portion of the housing as a radiating element.

The electronic devices may include electronic components for providing various functions. For example, an electronic device may include key button switches, an acoustic sensor, and a biometric sensor. The electronic components may be at least partially exposed through the housing to form an exterior of the electronic device, or may be disposed within the housing to be adjacent to the housing. In addition, the electronic devices may include a connecting member (e.g., a flexible printed circuit board) that operatively connects the plurality of electronic components.

### DISCLOSURE OF THE INVENTION

### TECHNICAL PROBLEM

The performance of an antenna may be degraded due to electronic components adjacent to a housing forming the antenna and a connecting member operatively connecting the electronic components. For example, electromagnetic noise generated from the electronic components may affect the radiation performance of the antenna. For another example, the connecting member operatively connecting electronic components acts as a radiating element of the antenna, so that unwanted parasitic components may be generated.

According to one embodiments of the present disclosure, a printed circuit board connecting a plurality of electronic components capable of reducing or preventing degradation of antenna performance and a wearable electronic device including the same may be provided.

### TECHNICAL SOLUTION

According to an aspect of the present disclosure, there is provided a wearable electronic device including a frame forming a side wall, a printed circuit board disposed within the frame and including at least one ground portion, and a connecting member at least a portion of which extends along the side wall. The connecting member includes an extension portion extending along the side wall, a first portion extending from a first end of the extension portion and connected to the printed circuit board, a second portion extending from a second end of the extension portion and connected to a conductive region of the printed circuit board, and a conductive trace extending from the first portion to the second portion through the extension portion. The conductive trace is electrically connected to the at least one ground portion through the conductive region of the printed circuit board. The printed circuit board includes a conductive pattern extending from the conductive region.

### ADVANTAGEOUS EFFECTS

According to embodiments disclosed herein, it is possible to reduce or prevent antenna performance degradation due to noise and/or parasitic components through an electrical loop structure provided by a printed circuit board.

According to the embodiments disclosed herein, it is possible to shift a resonant frequency and a parasitic component frequency through a conductive pattern connected to the electrical loop structure, and to improve the efficiency of an antenna.

Besides, various effects may be provided that are directly or indirectly identified through the present disclosure.

### BRIEF DESCRIPTION OF THE DRAWINGS

FIG. 1 is a perspective view of the front of a mobile electronic device according to one embodiment.
FIG. 2 is a perspective view of the back of the electronic device according to one embodiment.
FIG. 3 is a developed perspective view of an electronic device according to one embodiment.
FIG. 4 is a perspective view showing some components of an electronic device according to one embodiment.
FIG. 5 is a perspective view showing some components of the electronic device according to one embodiment.
FIG. 6 is a view showing a connecting member according to one embodiment.
FIG. 7 illustrates a second surface of a printed circuit board according to one embodiment.
FIG. 8 illustrates a first surface of the printed circuit board according to one embodiment.
FIG. 9a is a graph showing antenna radiation efficiency of an electronic device according to a comparative example and an electronic device according to an embodiment of the present disclosure.
FIG. 9b is a graph showing antenna radiation coefficients of the electronic device according to the comparative example and the electronic device according to the embodiment of the
FIG. 10 is a graph showing antenna radiation efficiency according to a length of a fifth pattern according to the embodiment of the present disclosure.
FIG. 11a shows radiation efficiency according to a line width of a conductive pattern when the fifth pattern is connected to at least one ground portion.
FIG. 11b is a graph of FIG. 11a corresponding to a first band of 650 MHz to 900 MHz.
FIG. 11c is a graph of FIG. 11a corresponding to a second band of 1500 MHz to 2200 MHz.
FIG. 12 is a block diagram illustrating an electronic device in a network environment according to various embodiments.

With respect to the description of the drawings, the same or similar reference signs may be used for the same or similar elements.

### MODE FOR CARRYING OUT THE INVENTION

Hereinafter, various embodiments disclosed in the present disclosure will be described with reference to the accompanying drawings. However, this is not intended to limit the present disclosure to the specific embodiments, and it is to be construed to include various modifications, equivalents, and/or alternatives of embodiments of the present disclosure. In addition, duplicate descriptions for configurations having the same reference numerals may be omitted.

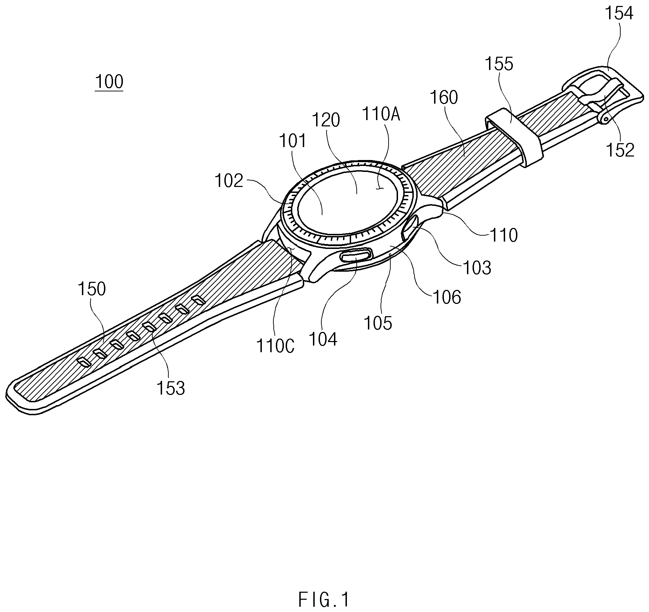

FIG. 1 is a perspective view of the front of a mobile electronic device according to one embodiment.

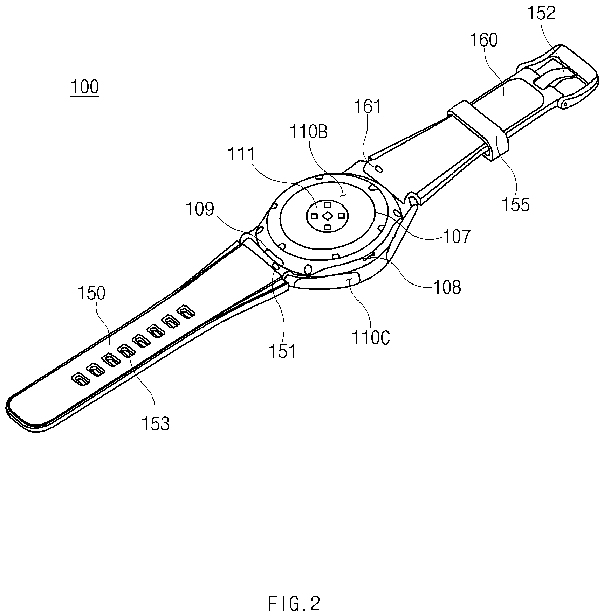

FIG. 2 is a perspective view of the back of the electronic device according to one embodiment.

FIGS. 1 and 2, an electronic device 100 according to one embodiment may include a housing 110 including a first surface (or front surface) 110A, a second surface (or back surface) 110B, and a side surface 110C surrounding a space between the first surface 110A and the second surface 110B, and coupling members 150 and 160 connected to at least a portion of the housing 110 and configured to detachably couple the electronic device 100 to a body part (e.g., a wrist or the like) of a user. In one embodiment, the housing 110 may be referred to as a structure forming a portion of the first surface 110A, the second surface 110B, and the side surface 110C. According to one embodiment, the first surface 110A may be formed by a front plate 101 (e.g., a glass plate or a polymer plate including various coating layers) that is at least partially substantially transparent. The second surface 110B may be formed by a back plate 107. The back plate 107 may include a substantially transparent region and/or substantially opaque region. The back plate 107 may be formed, for example, by coated or colored glass, ceramic, polymer, metal (e.g., aluminum, stainless steel (STS), or magnesium), or a combination of at least two of the materials. The side surface 110C may be coupled to the front plate 101 and the back plate 107, and may be formed by a frame 106 containing metal and/or polymer. The frame 106 may be referred to as a frame structure, a side bezel structure, or a side member. In one embodiment, the back plate 107 and the frame 106 may be integrally formed and contain the same material (e.g., a metal material such as aluminum), but are not limited thereto. The coupling members 150 and 160 may be formed of various materials and in various shapes. For example, the coupling members 150 and 160 may be formed of a woven material, leather, rubber, urethane, metal, ceramic, or a combination of at least two of the materials.

According to one embodiment, the electronic device 100 may include at least one of a display 120, audio modules 105 and 108, a sensor module 111, key input devices 102, 103, and 104, and connector holes 109. In some embodiments, the electronic device 100 may omit at least one of the components (e.g., the connector holes 109) or may additionally include other components.

The display 120 may be exposed through a significant portion of the front plate 101. For example, the display 120 may be visually seen through a transparent region of the front plate 101. The shape of the display 120 may be a shape corresponding to the shape of the front plate 101, and may have various shapes such as a circular shape, an oval shape, or a polygonal shape. The display 120 may be combined with or disposed to be adjacent to a touch sensing circuit, a pressure sensor capable of measuring the intensity (pressure) of the touch, and/or a fingerprint sensor.

The audio modules 105 and 108 may include a microphone hole 105 and a speaker hole 108. The microphone hole 105 may have a microphone for acquiring external sound disposed therein, and in some embodiments, a plurality of microphones may be disposed to detect the direction of sound. The speaker hole 108 may be used as an external speaker and a call receiver. In some embodiments, the speaker holes 107 and 114 and the microphone hole 105 may be implemented as one hole, or a speaker may be included without the speaker holes 107 and 114 (e.g., a piezo speaker).

The sensor module 111 may generate an electrical signal or data value corresponding to an internal operational state or an external environmental state of the electronic device 100. The sensor module 111 may include, for example, a biometric sensor module 111 (e.g., an HRM sensor) disposed on the second surface 110B of the housing 110. The electronic device 100 may further include a sensor module which is not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The key input device 102, 103, and 104 may be disposed on the first surface 110A of the housing 110, and may include a wheel key 102 rotatable in at least one direction, and/or side key buttons 103 and 104 disposed on the side surface 110C of the housing 110. The wheel key may have a shape corresponding to the shape of the front plate 101. In other embodiments, the electronic device 100 may not include some or all of the key input devices 102, 103, and 104 or may further include other key input devices not illustrated. At least some of the key input devices 102, 103, and 104 may be implemented in other forms, such as soft keys, on the display 120.

Although not illustrated, the electronic device 100 may further include a connector hole. The connector hole may accommodate a connector (e.g., a USB connector) for transmitting and/or receiving electric power and/or data to and/or from an external electronic device, or accommodate a connector (e.g., an earphone connector) for transmitting and/or receiving audio signals to and/or from an external electronic device.

The coupling members 150 and 160 may be detachably coupled to at least a partial region of the housing 110 using locking members 151 and 161. The coupling members 150 and 160 may include one or more of a fixing member 152, a fixing member fastening hole 153, a band guide member 154, and a band fixing ring 155.

The fixing member 152 may be configured to fix the housing 110 and the coupling members 150 and 160 to a body part (e.g., a wrist or the like) of the user. The fixing member fastening hole 153 may fix the housing 110 and the coupling members 150 and 160 to the user's body part corresponding to the fixing member 152. The band guide member 154 may be configured to limit the range of movement of the fixing member 152 when the fixing member 152 is fastened to the fixing member fastening hole 153, thereby making it possible for the coupling members 150 and 160 to be closely coupled to the user's body part. The band fixing ring 155 may limit the range of movement of the coupling members 150 and 160 in a state in which the fixing member 152 and the fixing member fastening hole 153 are fastened. However, the configuration that enables the electronic device 100 to be worn on the user's body, such as the fixing member 152 of the coupling members 150 and 160 and the fixing member fastening hole 153, is not limited to the above-described example, and various mechanisms may be applied.

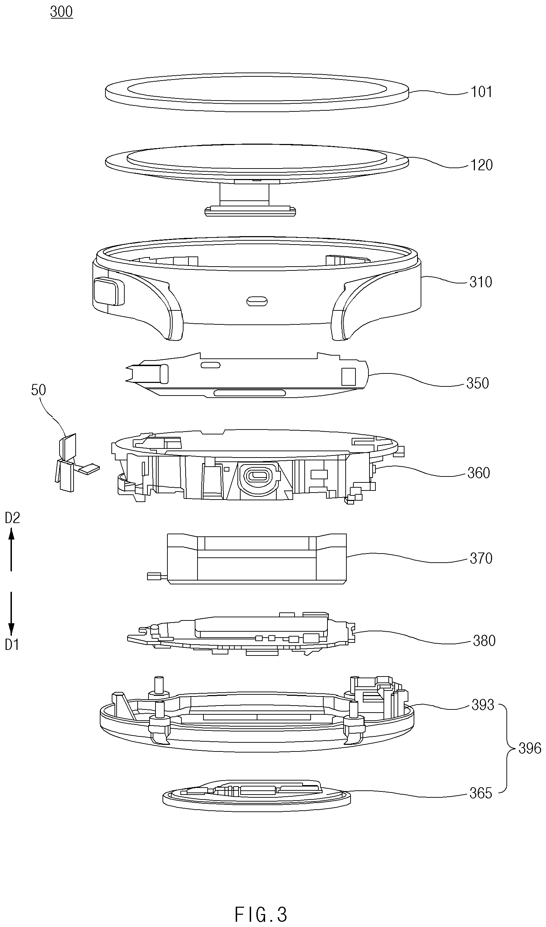

FIG. 3 is a developed perspective view of an electronic device according to one embodiment. Referring to FIG. 3, an electronic device 300 (e.g., the electronic device 100 in FIG. 1) may include a front plate 101, a display 120, a frame 310 (e.g., the frame 106 in FIG. 1), a first antenna 350, a bracket 360, a battery 370, a printed circuit board 380, a connecting member 50, and a back plate 396.

The front plate 101 may be disposed at an upper portion of the frame 310 (e.g., in a second direction D2). The back plate 396 (e.g., the back plate 107 in FIG. 1) may be disposed at a lower portion of the frame 310 (e.g., in a first direction D1). The back plate 396 may include a back case 393 and a back cover 365. The back cover 365 may be disposed on one surface of the back case 393 (e.g., a surface facing the first direction D1). The back case 393 may be coupled to the frame 310. The back cover 365 may be coupled to the back case 393. In another embodiment, the back case 393 and the back cover 365 may be integrally formed.

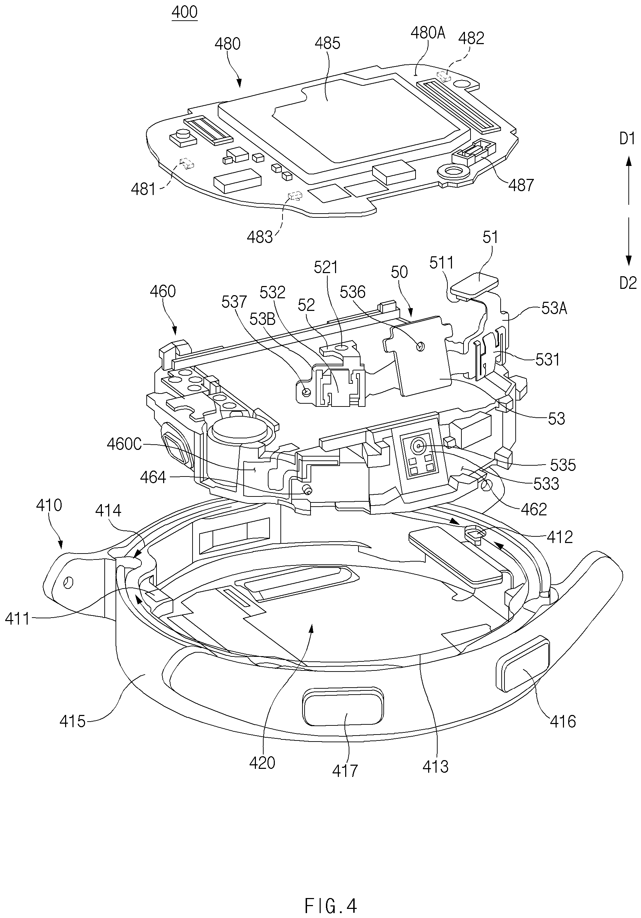

The frame 310 may surround a space between the front plate 101 and the back plate 396. For example, the frame 310 may include a portion (e.g., a side wall 415 in FIG. 4a) extending from the front plate 101 to the back plate 396 to surround the space.

The front plate 101 may be coupled to the upper portion of the frame 310 (e.g., in the second direction D2). The back plate 396 may be coupled to the lower portion of the frame 310 (e.g., in the first direction D1). Between the frame 310 and the back case 393, a sealing member (e.g., a waterproof tape or a waterproof adhesive tape) configured to block moisture and foreign substances from flowing into the interior of the electronic device 300 from the outside may be interposed. The front plate 101, the frame 310, and the back plate 396 coupled together may define an internal space of the electronic device 300. In an internal space, the display 120, the first antenna 350, the bracket 360, the battery 370, the printed circuit board 380, and the connecting member 50 may be disposed. At least a portion of the front plate 101, the frame 310, and the back plate 396 may be referred to as a housing of the electronic device 300 (e.g., the housing 110 in FIG. 1).

The display 120 may be disposed between the front plate 101 and the bracket 360. The display 120 may be at least partially accommodated within the frame 310. The display 120 may be attached to a back surface of the front plate 101 (e.g., a surface facing the first direction D1). For example, the display 120 may be attached to the front plate 101 by an optical adhesive member (e.g., an optically clear adhesive (OCA) or optically clear resin (OCR)).

The bracket 360 may be disposed inside the frame 310. The bracket 360 may be surrounded by the frame 310. The bracket 360 may be at least partially spaced apart from an inner surface of the frame 310. The connecting member 50 may be disposed in a space defined by the bracket 360 and the frame 310 being separated.

The display 120 and the first antenna 350 may be disposed on one surface (e.g., in the second direction D2) of the bracket 360, and the battery 370 and the printed circuit board 380 may be disposed on the other surface (e.g., in the first direction D1). The bracket 360 may support the display 120, the first antenna 350, the battery 370, the printed circuit board 380, and the connecting member 50. The bracket 360 may be referred to as a supporting member.

The bracket 360 may be provided separately from the frame 310 and coupled to the frame 310, or may be formed integrally with the frame 310. The bracket 360 may be formed of, for example, a metallic material and/or a non-metallic (e.g., a polymer such as plastic) material.

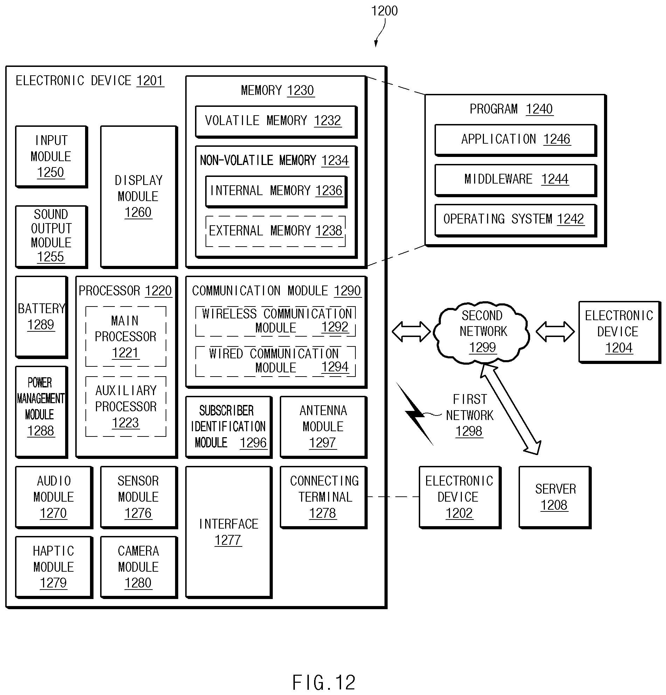

The printed circuit board 380 may be disposed between the bracket 360 and the back plate 396. On the printed circuit board 380, a processor (e.g., a processor 1220 in FIG. 12), a memory (e.g., a memory 1230 in FIG. 12), and/or an interface (e.g., an interface 1277 in FIG. 12) may be installed. The processor may include, for example, one or more of a central processing unit, an application processor, a graphic processing unit (GPU), an application processor sensor processor, or a communication processor. The memory may include, for example, a volatile memory or a non-volatile memory. The interface may include, for example, a high definition multimedia interface (HDMI), a universal serial bus (USB) interface, a secure digital (SD) card interface, and/or an audio interface. The interface may include a connector (e.g., a connecting terminal 1278 in FIG. 12, such as a USB connector, an SD card/MMC connector, or an audio connector, for electrically or physically connecting the electronic device 300 to an external electronic device.

The battery 370 may be a device for supplying electric power to at least one of the components of the electronic device 300, and may include, for example, a secondary cell which is rechargeable. The battery 370 may be disposed between the bracket 360 and the printed circuit board 380. The battery 370 may be at least partially disposed within an accommodating space (e.g., a recess) formed in one surface of the bracket 360 (e.g., a surface facing the first direction D1). The battery 370 may be attached to the bracket 360 through an adhesive member (an adhesive or an adhesive tape).

The first antenna 350 may be disposed between the display 120 and the bracket 360. The first antenna 350 may include, for example, a near field communication (NFC) antenna, a wireless charging antenna, and/or a magnetic secure transmission (MST) antenna. The first antenna 350 may, for example, perform short-range communication with an external device, wirelessly transmit and receive power required for charging, and transmit a short-range communication signal or a self-based signal including payment data.

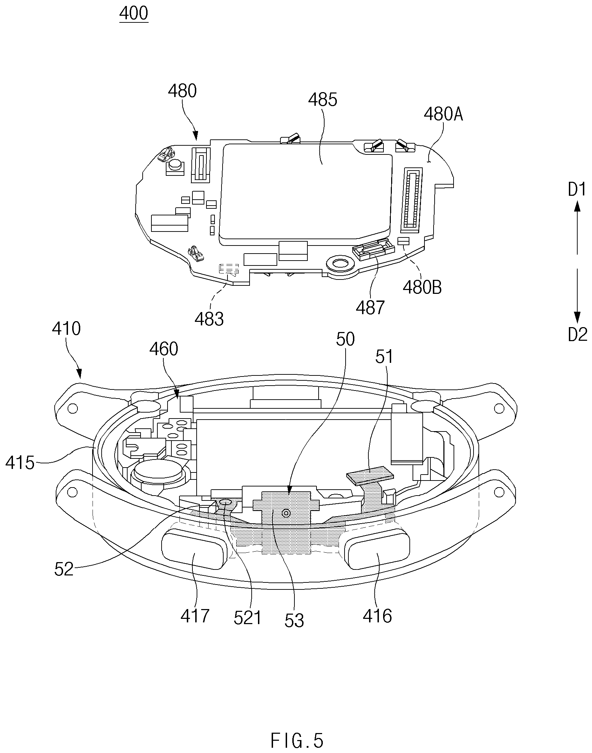

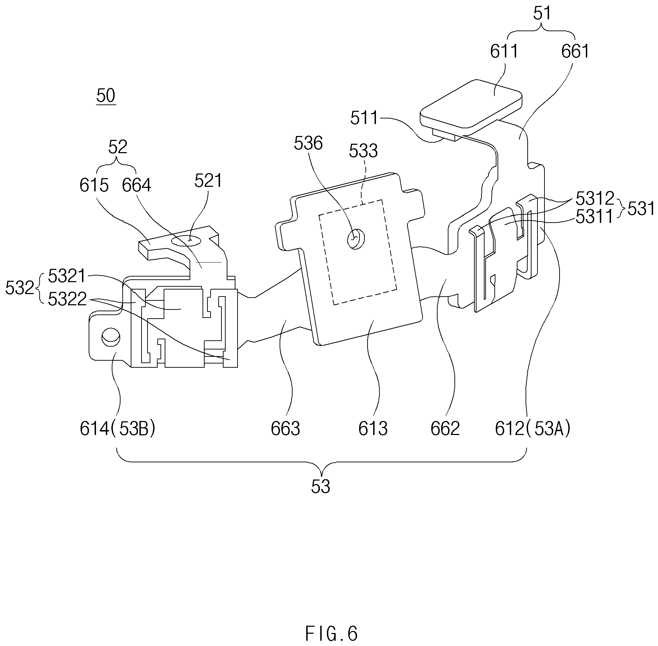

FIG. 4 is a perspective view showing some components of an electronic device according to one embodiment. FIG. 5 is a perspective view showing some components of the electronic device according to one embodiment. FIG. 6 is a view showing a connecting member according to one embodiment. Referring to FIGS. 4, 5, and 6, an electronic device 400 (e.g., the electronic device 300 in FIG. 3) according to one embodiment may include a printed circuit board 480, a bracket 460, a frame 410, a connecting member 50, a first button 416, a second button 417, and a display 420.

In one embodiment, the printed circuit board 480 (e.g., the printed circuit board 380 in FIG. 3) may include a first surface 480A and a second surface 480B facing a direction opposite to the first surface 480A. For example, the first surface 480A of the printed circuit board 480 may face a first direction D1, and the second surface 480B thereof may face a second direction D2 opposite to the first direction D1.

In one embodiment, on the first surface 480A and/or the second surface 480B of the printed circuit board 480, various electronic components (e.g., the processor 1220 and a wireless communication module 1292 in FIG. 12) may be disposed, although not illustrated. A protection member 485 that protects electronic components disposed on the printed circuit board 480 may be disposed on the first surface 480A and/or the second surface 480B of the printed circuit board 480. For example, the protection member 485 may include an insulating member (e.g., a resin) covering the electronic components to protect the electronic components from external moisture or the like and a conductive layer (e.g., conformal shielding) formed on a surface of the insulating member to shield electromagnetic interference (EMI), and/or include a shield can for covering electronic components. However, the protection member 485 is not limited thereto.

In one embodiment, the printed circuit board 480 may be disposed on the bracket 460. For example, the printed circuit board 480 may be disposed on the bracket 460 in the first direction D1. The second surface 480B of the printed circuit board 480 may face the bracket 460.

In one embodiment, the frame 410 (e.g., the frame 310 in FIG. 3) may include a side wall 415 forming at least a portion of a side surface (e.g., the side surface 110C in FIG. 2) of the electronic device 400. The side wall 415 may extend in a height direction (e.g., the first direction D1) of the electronic device 400. The side wall 415 may surround the bracket 460. When the frame 410 is viewed from above (e.g., when viewed in the first direction D1 or the second direction D2), the shape of the side wall 415 may be substantially circular. However, the shape is not limited thereto, and the side wall 415 may have various shapes such as a quadrangle, a quadrangle with rounded corners, a polygon, or the like.

In one embodiment, the frame 410 may include a first point 411 and a second point 412. The first point 411 and/or the second point 412 may be formed directly on the side wall 415, or may be formed in a portion that protrudes inwardly from the side wall 415.

In one embodiment, the frame 410 may include a first portion 413 and a second portion 414. The first portion 413 may include a portion extending in one direction (e.g., counterclockwise) from the first point 411 of the side wall 415 to the second point 412. The first portion 413 may have a first length from the first point 411 of the side wall 415 to the second point 412 based on the one direction. The second portion 414 may include a portion extending in a direction other (e.g., clockwise) than the one direction from the first point 411 of the side wall 415 to the second point 412. The second portion 414 may have a second length from the first point 411 of the side wall 415 to the second point 412, based on the direction other than the one direction. The second length may be shorter than the first length.

In one embodiment, the electronic device 400 may include an antenna that includes at least a portion of the frame 410 as an antenna element. In one embodiment, the frame 410 may be powered at the first point 411 and grounded at the second point 412 to operate as an antenna for transmitting and receiving wireless signals.

In one embodiment, the first point 411 of the frame 410 may be connected to a first connector 481 disposed on the second surface 480B of the printed circuit board 480. For example, the first point 411 of the frame 410 may be electrically connected to be in contact with the first connector 481. In one embodiment, a wireless communication circuit (e.g., the wireless communication circuit 1292 in FIG. 12) disposed on the printed circuit board 480 may be electrically connected to the first point 411 of the frame 410 through a transmission line formed on the printed circuit board 480 and the first connector 481 electrically connected to the transmission line. The first connector 481 may include, for example, a c-clip connector, but is not limited thereto. For example, the first connector 481 may include a coaxial cable.

In one embodiment, the second point 412 of the frame 410 may be connected to a second connector 482 disposed on the second surface 480B of the printed circuit board 480. For example, the second point 412 of the frame 410 may be electrically connected to be in contact with the second connector 482. The second connector 482 may include, for example, a c-clip connector, but is not limited thereto.

In one embodiment, the second point 412 of the frame 410 may be electrically connected to a ground plane of the printed circuit board 480 via the second connector 482. The ground plane may include a conductive layer (e.g., a copper layer) positioned on at least one layer of the printed circuit board 480. The ground plane may be formed as one or a plurality of regions on one or a plurality of layers of the printed circuit board. In this respect, the ground plane of the printed circuit board 480 may be referred to as "at least one ground portion."

In one embodiment, the frame 410 may form a first resonant frequency corresponding to a first designated band (e.g., a low-band (LB) below 1 GHz, but not limited thereto) and a second resonant frequency corresponding to a second designated band (e.g., a mid-band (MB) from 1 GHz to 2.3 GHz, but not limited thereto). For example, the frame 410 may be powered at the first point 411 and short-circuited to the ground portion at the second point 412 to form the first resonant frequency band and/or the second resonant frequency band. The first resonant frequency and the second resonant frequency may vary depending on a circumferential length (e.g., the first length and the second length) of each of the first portion 413 and the second portion 414 of the frame 410 divided into the first point 411 and the second point 412. The first resonant frequency and the second resonant frequency may vary depending on current paths including the first portion 413 and the second portion 414 of the frame 410, respectively.

In one embodiment, the wireless communication circuit may transmit and receive wireless signals of the first designated band and the second designated band by supplying power to the first point 411 of the frame 410. In FIG. 4, only the first point 411 and the second point 412 are shown, but the present disclosure is not limited thereto. For example, the frame 410 may further include at least one feed point and/or at least one ground point.

In one embodiment, the bracket 460 (e.g., the bracket 360 in FIG. 3) may be at least partially accommodated within a space formed by the frame 410. For example, the bracket 460 may be disposed inside the side wall 415 of the frame 410.

In one embodiment, the bracket 460 may be at least partially spaced apart from the side wall 415 of the frame 410. For example, the bracket 460 may include a side surface 460C facing the side wall 415, and the side surface 460C of the bracket 460 may be at least partially spaced apart from the side wall 415.

In one embodiment, the bracket 460 may support the printed circuit board 480 and the connecting member 50. In one embodiment, the connecting member 50 may include a flexible printed circuit board or a rigid-flexible printed circuit board, at least a portion of which may be bent.

In one embodiment, the connecting member 50 may be at least partially disposed between the bracket 460 and the side wall 415 of the frame 410. The connecting member 50 may be at least partially seated in an accommodating groove 462 formed on the side surface 460C of the bracket 460 facing the side wall 415.

In one embodiment, the connecting member 50 may be disposed between the bracket 460 and the first portion 413 of the frame 410. For example, the connecting member 50 may be closer to the first portion 413 of the frame 410 than to the second portion 414. However, the connecting member 50 is not limited thereto, and for another example, unlike that illustrated, the connecting member 50 may be disposed between the bracket 460 and the second portion 414 of the frame 410.

In one embodiment, the connecting member 50 may be fixedly disposed on the side surface 460C of the bracket 460. For example, the connecting member 50 may be coupled to the bracket 460 in such a way that a protrusion 464 formed in the accommodating groove 462 and a hole 537 formed in the connecting member 50 are insertion-coupled together. For another example, the connecting member 50 may be coupled to the bracket 460 through an adhesive member (e.g., a double-sided tape) or a fixing member (e.g., a screw).

In one embodiment, the connecting member 50 may be disposed to at least partially overlap the side wall 415 of the frame 410 and/or the bracket 460 when the side surface of the electronic device 400 is viewed (e.g., when viewed in a direction perpendicular to the first direction D1).

In one embodiment, the connecting member 50 may include a first portion 51, a second portion 52, and an extension portion 53. In one embodiment, the extension portion 53 may be positioned between the bracket 460 and the side wall 415. The extension portion 53 may extend along the side wall 415 of the frame 410 (or the side surface 460C of the bracket 460). The extension portion 53 may be at least partially accommodated in the accommodating groove 462 of the bracket 460.

In one embodiment, the extension portion 53 may include a first end 53A and a second end 53B. The first end 53A may be positioned between the first button 416 and the bracket 460. The second end 53B may be positioned between the second button 417 and the bracket 460.

In one embodiment, various components of the electronic device 400 may be disposed on the extension portion 53. For example, a first component 531, a second component 532, and a third component 533 may be disposed on the extension portion 53.

In one embodiment, the first button 416 and the second button 417 may be at least partially exposed through the frame 410. In one embodiment, the first button 416 and the second button 417 may at least partially overlap the connecting member 50 when the side surface of the frame 410 (e.g., the side surface 110C in FIG. 2) is viewed (e.g., when viewed in a direction perpendicular to the first direction D1). In one embodiment, the first button 416 and the second button 417 may at least partially overlap the extension portion 53 of the connecting member 50 when the side wall 415 of the frame 410 is viewed from the front (e.g., when viewed in the direction perpendicular to the first direction D1). For example, the first button 416 may at least partially overlap the first end 53A of the extension portion 53, and the second button 417 may at least partially overlap the second end 53B of the extension portion 53.

In one embodiment, a display 420 (e.g., the display 120 in FIG. 3) may be disposed within the frame 410. In one embodiment, the bracket 460 may be disposed between the display 420 and the printed circuit board 480. The printed circuit board 480 may be disposed and supported in one direction (e.g., the first direction D1) of the bracket 460, and the display 420 may be disposed and supported in the other direction (e.g., the second direction D2).

In one embodiment, the first component 531 and/or the second component 532 may include a biometric sensor. For example, the first component 531 and/or the second component 532 may include, but are not limited to, a bioelectrical impedance analysis sensor (BIA sensor) and/or an electrocardiogram sensor (ECG sensor). The biometric sensor may include a first conductive structure and a second conductive structure electrically connected to the first button 416 and the second button 417 to obtain biometric information. The first conductive structure and the second conductive structure may include, for example, a conductive plate. The conductive structure may include contact portions 5311 and 5321 that at least partially contact the first button 416 and the second button 417 and fixing portions 5312 and 5322 that extend from the contact portions 5311 and 5321 and are electrically connected to the first end 53A and the second end 53B of the connecting member 50.

In one embodiment, the first component 531 may include a first dome switch. The first dome switch may be disposed between the first conductive structure and one surface of the connecting member 50. The first dome switch may generate an electrical signal by being pressed by the first button 416 (e.g., the key input device 104 in FIG. 1) according to the user's operation. In one embodiment, the second component 532 may include a second dome switch. The second dome switch may be disposed between the second conductive structure and one surface of the connecting member 50. The second dome switch may generate an electrical signal by being pressed by the second button 417 according to the user's operation.

In one embodiment, the first conductive structure of the first component 531 may be electrically connected to the first button 416 formed at least partially of a conductive material (e.g., metal). In one embodiment, the second conductive structure of the second component 532 may be electrically connected to the second button 417 formed at least partially of a conductive material. The first component 531 and the first button 416 may act as a first electrode for detecting biometric information about a user when a user's body comes into contact with the first button 416. The second component 532 and the second button 417 may act as a second electrode for detecting biometric information about the user when a user's body comes into contact with the second button 417. In one embodiment, the signal detected through the first electrode and the second electrode may be provided to a processor (e.g., the processor 1220 in FIG. 12) of the electronic device 400 through the connecting member 50. The processor may obtain the biometric information about the user based on the detected signal. The biometric information and the first biometric information may include, but is not limited to, information on the components of the user's body and/or information on the user's electrocardiogram.

The electronic device 400 according to one embodiment may include an analog-to-digital converter (not illustrated) that processes an analog signal detected from the biometric sensor into a digital signal and transmits the digital signal to the processor. The analog-to-digital converter may be disposed on the printed circuit board 480, but is not limited thereto.

In one embodiment, the third component 533 may be disposed between the first component 531 and the second component 532 in the extension portion 53. In one embodiment, the third component 533 may include an acoustic sensor. In one embodiment, the third component 533 may be positioned between the extension portion 53 and the bracket 460. In one embodiment, a microphone hole 535 through which sound is introduced may be formed in the third component 533, and the microphone hole 535 may be aligned with an opening 536 formed in the extension portion 53 to communicate therewith.

In one embodiment, the first component 531, the second component 532, and the third component 533 described above are not limited to the above-described example, and may be replaced with components having functions different from those described above.

In one embodiment, the first portion 51 of the connecting member 50 may extend from the first end 53A of the extension portion 53. The first portion 51 of the connecting member 50 may extend from the first end 53A of the extension portion 53 to face the first surface 480A of the printed circuit board 480. The first portion 51 may be disposed on the first surface 480A of the printed circuit board 480. For example, the first portion 51 may include a plug 511 of the connector, and a receptacle 487 of the connector may be disposed on the first surface 480A of the printed circuit board 480. The first portion 51 may be connected to the printed circuit board 480 in such a way that the plug 511 and the receptacle 487 are mutually coupled. However, in order for the connecting member 50 to be connected to the printed circuit board 480, the connector structure is not limited to that formed by the above-described receptacle and plug, and various methods may be used. Alternatively, the first portion 51 may be disposed on the second surface 480B of the printed circuit board 480.

In one embodiment, at least one processor (e.g., the processor 1220 in FIG. 12) disposed on the printed circuit board 480 may be operatively connected to the first component 531, the second component 532, and the third component 533 through the connecting member 50. For example, the at least one processor may be electrically connected to the first component 531, the second component 532, and the third component 533 through the printed circuit board 480 and the conductive trace (or pattern) formed on the connecting member 50. In one embodiment, the at least one processor may transmit and/or receive electrical signals to (and/or from) the first component 531, the second component 532, and the third component 533. The electrical signals may be transmitted through the first portion 51 of the connecting member 50.

In one embodiment, the second portion 52 of the connecting member 50 may extend from the second end 53B of the extension portion 53. The second portion 52 of the connecting member 50 may extend from the second end 53B of the extension portion 53 to face the second surface 480B of the printed circuit board 480. The second portion 52 may be disposed on the second surface 480B of the printed circuit board 480. In the second portion 52, a conductive region 521 (or conductive pad) in which the conductive pattern of the connecting member 50 is partially exposed may be formed. The conductive region 521 may face the second surface 480B of the printed circuit board 480. The conductive region 521 may be connected to a third connector 483 arranged on the second surface 480B of the printed circuit board 480. For example, the conductive region 521 may be in contact with the third connector 483. The conductive region 521 may be electrically connected to the third connector 483. The third connector 483 may include, but is not limited to, a C-clip, for example. Alternatively, the second portion 52 of the connecting member 50 may be disposed on the first surface 480A of the printed circuit board 480.

In one embodiment, the connecting member 50 may include a plurality of conductive traces (or patterns). The plurality of conductive traces may include signal lines and power lines for the operation of the first component 531, the second component 532, and the third component 533, and a plurality of ground lines. At least some of the plurality of ground lines may be electrically connected, directly or indirectly (e.g., via another ground line), to the conductive region 521 of the second portion 52. At least some of the plurality of ground lines may be electrically connected to the third connector 483 through the conductive region 521.

In one embodiment, the connecting member 50 may be at least partially bendable. In one embodiment, the connecting member 50 may include flexible portion(s) and rigid portion(s). For example, referring to FIG. 6, the connecting member 50 may include a first rigid portion 611, a second rigid portion 612, a third rigid portion 613, a fourth rigid portion 614, a fifth rigid portion 615, a first flexible portion 661, a second flexible portion 662, a third flexible portion 663, and a fourth flexible portion 664.

The plug 511 may be disposed on the first rigid portion 611. In one embodiment, the first flexible portion 661 may connect the first rigid portion 611 and the second rigid portion 612. For example, the first flexible portion 661 may extend from the first rigid portion 611 to the second rigid portion 612. In one embodiment, the first rigid portion 611 and the first flexible portion 661 may be referred to as the first portion 51 of the connecting member 50 in that they extend from the first end 53A of the extension portion 53.

The first component 531 may be disposed on the second rigid portion 612. The second flexible portion 662 may connect the second rigid portion 612 and the third rigid portion 613. For example, the second flexible portion 662 may extend from the second rigid portion 612 to the third rigid portion 613.

The third component 533 may be disposed on the third rigid portion 613. The opening 536 communicating with the microphone hole (e.g., 535 in FIG. 4) of the third component 533 may be formed in the third rigid portion 613.

The third flexible portion 663 may connect the third rigid portion 613 and the fourth rigid portion 614. For example, the third flexible portion 663 may extend from the third rigid portion 613 to the fourth rigid portion 614 in a direction away from the second flexible portion 662. The second component 532 may be disposed on the fourth rigid portion 614.

The second rigid portion 612, the second flexible portion 662, the third rigid portion 613, the third flexible portion 663, and the fourth rigid portion 614 may extend along the side wall 415 of the frame 410 or the side surface 460C of the bracket 460. In this respect, the second rigid portion 612, the second flexible portion 662, the third rigid portion 613, the third flexible portion 663, and the fourth rigid portion 614 may be referred to as the extension portion 53 of the connecting member 50. The first end 53A of the connecting member 50 may be understood to include at least a portion of the second rigid portion 612. In one embodiment, the second end 53B of the connecting member 50 may be understood to include at least a portion of the fourth rigid portion 614.

The conductive region 521 may be formed on the fifth rigid portion 615. The conductive region 521 may include a conductive pad for electrical connection to the third connector 483.

The fourth flexible portion 664 may connect the fourth rigid portion 614 and the fifth rigid portion 615. The fourth flexible portion 664 may extend from the fourth rigid portion 614 to the fifth rigid portion 615.

The fourth flexible portion 664 and the fifth rigid portion 615 may be referred to as the second portion 52 of the connecting member 50 in that they extend from the second end 53B of the extension portion 53.

However, the distinction between the above-described rigid portions and the flexible portions is exemplary, and various design changes may be possible. For example, when the third component 533 is omitted, the third rigid portion 613 may be replaced with the flexible portion. For another example, the first end 53A (or the second end 53B) of the extension portion 53 has been described as including at least a portion of the second rigid portion 612 (or the fourth rigid portion 614), but in other embodiments, the first end 53A and/or the second end 53B of the extension portion 53 may be formed at least partially as the flexible portion.

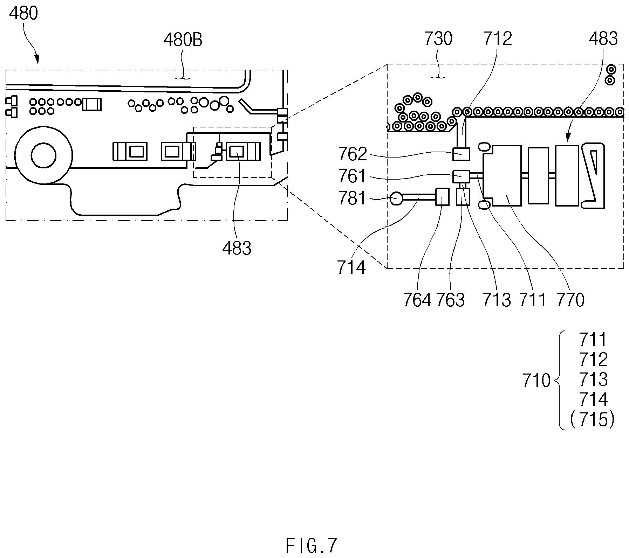

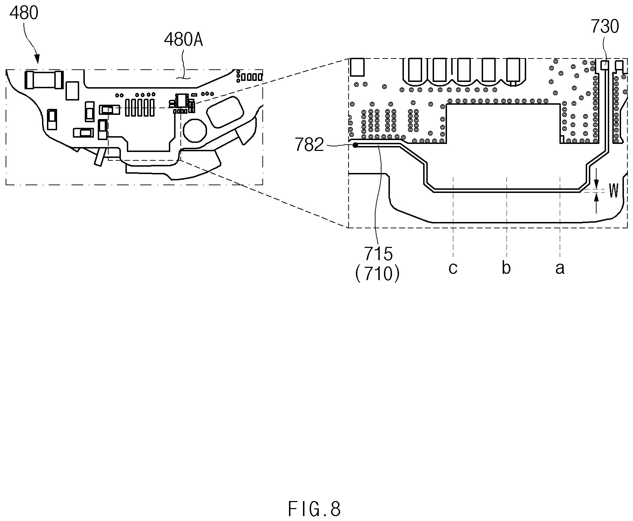

FIG. 7 illustrates a second surface of a printed circuit board according to one embodiment. FIG. 8 illustrates a first surface of the printed circuit board according to one embodiment.

Referring to FIGS. 7 and 8, a printed circuit board 480 according to one embodiment may include a conductive pattern 710 electrically connected to a third connector 383, a first conductive via 781, a second conductive via 782, and at least one ground portion 730. The conductive pattern 710 may be formed of a conductive material (e.g., a copper). The conductive pattern 710 may include a first pattern 711, a second pattern 712, a third pattern 713, a fourth pattern 714, and a fifth pattern 715. The conductive pattern 710 may further include a first land 761, a second land 762, and a third land 763.

The first pattern 711 may be electrically connected to the third connector 483. For example, the third connector 483 may be mounted on a conductive region 770 provided by the printed circuit board 480, and the first pattern 711 may be connected to the conductive region 770. The first pattern 711 may be electrically connected to the third connector 483 through the conductive region 770. The first pattern 711 may extend from the conductive region 770 to the first land 761. The first land 761 and the second land 762 may be electrically connected through a first circuit element (e.g., a resistor, an inductor, a capacitor). The first circuit element may be connected in series to the conductive pattern 710. However, the connecting configuration is not limited thereto, and for example, the first circuit element and the first land 761 and the second land 762 for disposing the first circuit element may be omitted. In this case, the first pattern 711 may be extended to the second pattern 712 to be directly connected to the second pattern 712. The second pattern 712 may extend from the second land 762 to at least one ground portion 730. The second pattern 712 may be electrically connected to at least one ground portion 730.

The third pattern 713 may extend from the first land 761 to the third land 763. The third land 763 may be electrically connected to a fourth land 764 through a second circuit element (e.g., a resistor, an inductor, a capacitor). The second circuit element may be connected in series to the conductive pattern 710. However, the connecting configuration is not limited thereto, and for example, the second circuit element and the third land 763 and the fourth land 764 for disposing the second circuit element may be omitted. In this case, the third pattern 713 may be extended to the fourth pattern 714 to be directly connected to the fourth pattern 714.

The fourth pattern 714 may extend from the fourth land 764 to the first conductive via 781. The fourth pattern 714 may be electrically connected to the first conductive via 781. In order to route conductive patterns 710 positioned on different layers of the printed circuit board 480, the first conductive via 781 may include a hole partially passing through the printed circuit board 480 and a conductive material (e.g., a copper) at least partially filling the hole.

The first conductive via 781 may be electrically connected to the second conductive via 782. For example, the first conductive via 781 may be connected to the second conductive via 782 through another conductive pattern or another conductive via that is not illustrated. The second conductive via 782 may be electrically connected to the fifth pattern 715.

In another embodiment, the second conductive via 782 may be omitted. In this case, the first conductive via 781 may be directly electrically connected to the fourth pattern 714 and the fifth pattern 715. The first conductive via 781 may route the fourth pattern 714 and the fifth pattern 715.

The fifth pattern 715 may extend from the second conductive via 782 to at least one ground portion 730. Based on FIG. 8, the fifth pattern 715 is illustrated as extending to the right from the second conductive via 782, but is not limited thereto. The fifth pattern 715 may extend in a different direction than the direction illustrated, for example to the left from the second conductive via 782.

The fifth pattern 715 may be electrically connected to at least one ground portion 730. The fifth pattern 715 may be formed on a layer different from at least one of the first pattern 711, the second pattern 712, the third pattern 713, and/or the fourth pattern 714. For example, the first pattern 711, the second pattern 712, the third pattern 713, and the fourth pattern 714 may be formed on the first layer (not necessarily the uppermost layer or the lowermost layer) of the printed circuit board 480, and the fifth pattern 715 may be formed on the second layer (not necessarily stacked on the first layer) that is different from the first layer. A physical length of the fifth pattern 715 may be longer than that of the first pattern 711, the second pattern 712, the third pattern 713, or the fourth pattern 714. Optionally, a third circuit element (e.g., a resistor, an inductor, a capacitor) may be connected in series to the the fifth pattern 715.

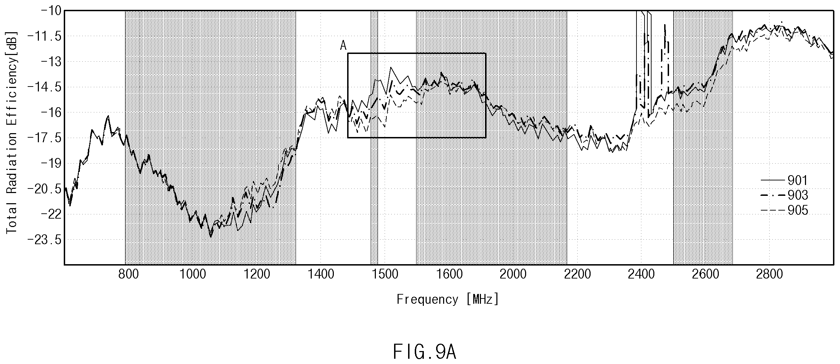

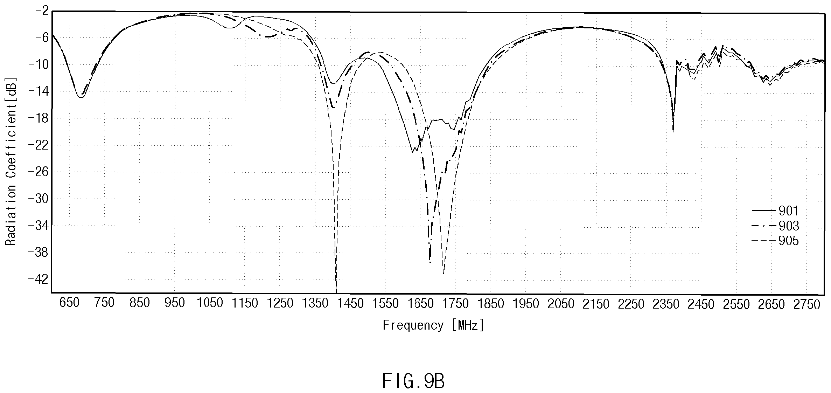

Alternatively, unlike the illustration in FIG. 8, the fifth pattern 715 may not be connected to at least one ground portion 730. For example, the fifth pattern 715 may extend from the second conductive via 782, but have an end formed by an open stub. FIG. 9a is a graph showing antenna radiation efficiency of an electronic device according to a comparative example and an electronic device according to an embodiment of the present disclosure, and FIG. 9b is a graph showing antenna radiation coefficients of the electronic device according to the comparative example and the electronic device according to the embodiment of the present disclosure. In FIGS. 9a and 9b, graph 901 is a graph of the electronic device according to the comparative example that does not include the third pattern 713, the fourth pattern 714, the first conductive via 781, the second conductive via 782, and the fifth pattern 715. In FIGS. 9a and 9b, graph 903 is a graph of a state in which the fifth pattern 715 is not connected to at least one ground portion 730 and an end of the fifth pattern 715 is electrically open. In FIGS. 9a and 9b, graph 905 is a graph of a state in which the fifth pattern 715 is electrically connected to at least one ground portion 730. Referring to FIGS. 9a and 9b, the radiation efficiency of graph 903 and graph 905 may be higher overall than that of graph 901. In addition, the radiation efficiency of graph 905 may be higher overall than that of graph 903. In particular, in a designated band A of about 1300 MHz to about 1800 MHz, the radiation efficiency of graph 903 may be higher than that of graph 901, and the radiation efficiency of graph 905 may be higher than that of graph 903.

Referring back to FIGS. 7 and 8, the fifth pattern 715 may have various lengths. For example, the fifth pattern 715 may extend from the second conductive via 782 to a first position a, a second position b, or a third position c. When the fifth pattern 715 extends to the first position a, the fifth pattern 715 may have a first length. When the fifth pattern 715 extends to the second position b, the fifth pattern 715 may have a second length. When the fifth pattern 715 extends to the third position c, the fifth pattern 715 may have a third length. The first length may be greater than the second length, and the second length may be greater than the third length. An end of the fifth pattern 715 corresponding to each of the first position a, the second position b, or the third position c may be open without being electrically connected to at least one ground portion 730.

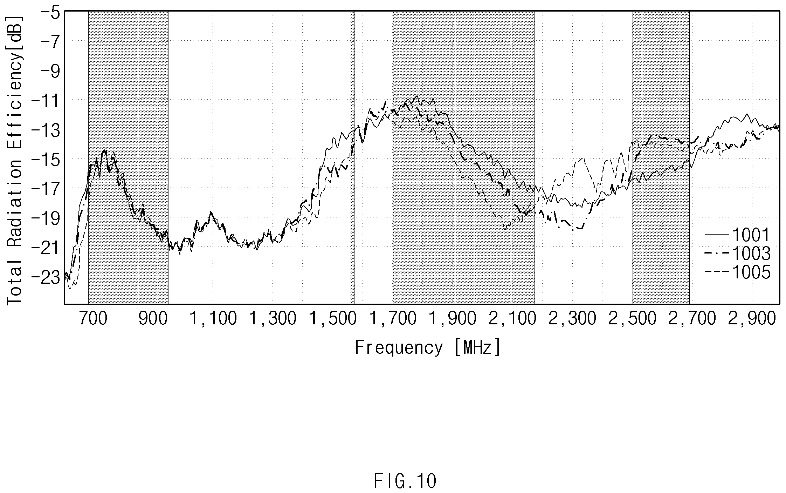

FIG. 10 is a graph showing antenna radiation efficiency according to a length of the fifth pattern 715 according to an embodiment of the present disclosure. In FIG. 10, graph 1001 shows the radiation efficiency of the electronic device when the fifth pattern 715 has the first length corresponding to the first position a. Graph 1003 shows the radiation efficiency of the electronic device when the fifth pattern 715 has the second length corresponding to the second position b. Graph 1005 shows the radiation efficiency of the electronic device when the fifth pattern 715 has the third length corresponding to the third position c. Referring to FIG. 10, as the length of the fifth pattern 715 becomes shorter, the antenna radiation efficiency may shift to a higher frequency band.

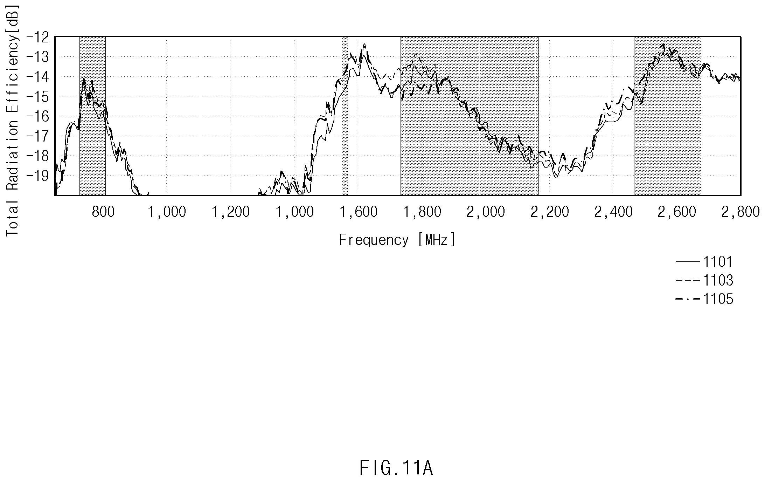

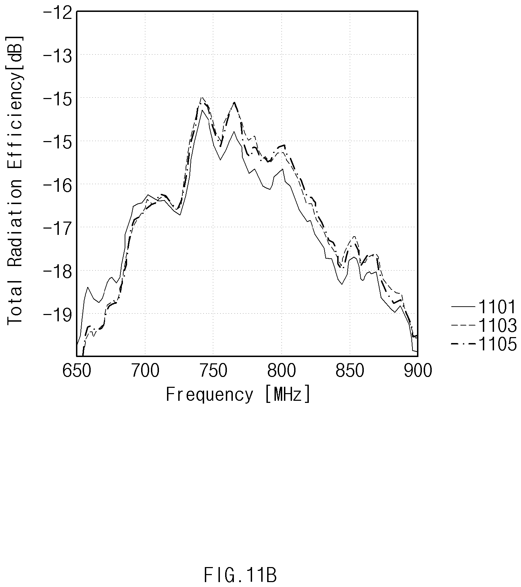

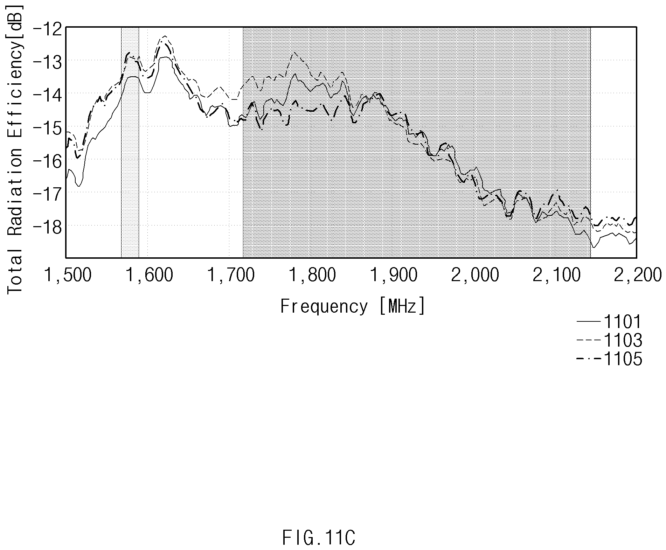

Referring back to FIGS. 7 and 8, the conductive pattern 710 may have a specified line width. For example, the fifth pattern 715 of the conductive pattern 710 may have a specified line width w. The line width of the conductive pattern 710 may be determined according to the radiation efficiency of the required frequency band. FIG. 11a shows the radiation efficiency according to the line width w of the conductive pattern 710 when the fifth pattern 715 is connected to at least one ground portion. FIG. 11b is a graph of FIG. 11a corresponding to a first band of 650 MHz to 900 MHz. FIG. 11c is a graph of FIG. 11a corresponding to a second band of 1500 MHz to 2200 MHz. In FIGS. 11a, 11b, and 11c, graph 1101 shows the radiation efficiency when the line width w of the conductive pattern 710 is 1.4 mm, graph 1103 shows the radiation efficiency when the line width w of the conductive pattern 710 is 2.0 mm, and graph 1105 shows the radiation efficiency when the line width w of the conductive pattern 710 is 2.5 mm. Referring to FIGS. 11a, 11b, and 11c, the radiation efficiency may vary depending on the line width w of the conductive pattern 710. For example, referring to FIG. 11b, in the first band, the radiation efficiency of graph 1003 and graph 1005 may be higher than the radiation efficiency of graph 1001. For example, referring to FIG. 11c, in the second band, the radiation efficiency of graph 1003 may be higher than the radiation efficiency of graph 1001 and graph 1005.

Referring to FIGS. 7 and 8, the third connector 483 may be electrically connected to at least one ground portion 730 through the conductive pattern 710. Referring to FIG. 5 together, the conductive region 521 of the connecting member 50 may be electrically connected to the third connector 483. A plurality of ground lines of the connecting member 50 may be electrically connected to at least one ground portion 730 of the printed circuit board 480 through the conductive region 521 and the third connector 483. The connecting member 50 may form a loop structure in which the first portion 51 is disposed on the printed circuit board 480 to be operatively connected to at least one processor and the second portion 52 is electrically connected to at least one ground portion 730 of the printed circuit board 480. By forming the loop structure between both ends of the connecting member 50 (e.g., the first portion 51 and the second portion 52), noise and/or parasitic components may be reduced, thereby reducing and/or preventing performance degradation of the antenna. The conductive pattern 710 may be electrically connected to the electrical loop structure. By expanding the ground loop structure by the conductive pattern 710, antenna efficiency may be improved. By adjusting the length and/or line width of the conductive pattern 710, the antenna efficiency of a required frequency band may be improved. In addition, by adjusting the length and/or line width of the conductive pattern 710, the antenna resonance frequency and parasitic resonance frequency may be shifted, thereby tuning the antenna efficiency of the required frequency band.

The conductive pattern 710 may be referred to as a printed circuit board embedded antenna (PEA).

In one embodiment, a wearable electronic device (e.g., the electronic device 400 in FIG. 4) may include a frame (e.g., the frame 410 in FIG. 4) including a side wall (e.g., the side wall 415 in FIG. 4) and at least partially forming an antenna, a printed circuit board (e.g., the printed circuit board 480 in FIG. 4) disposed within the frame and including at least one ground portion (e.g., the at least one ground portion 730 in FIG. 7), and a connecting member (e.g., the connecting member 50 in FIG. 4). The connecting member may include an extension portion (e.g., the extension portion 53 in FIG. 4) extending along the side wall, a first portion (e.g., the first portion 51 in FIG. 4) extending from a first end (e.g., the first end 53A in FIG. 4) of the extension portion and connected to the printed circuit board, a second portion (e.g., the second portion 52 in FIG. 4) extending from a second end (e.g., the second end 53B in FIG. 4) of the extension portion and connected to a conductive region (e.g., the conductive region 770 in FIG. 7) of the printed circuit board, and a conductive trace extending from the first portion to the second portion through the extension portion. The conductive trace may be electrically connected to the at least one ground portion through the conductive region of the printed circuit board. The printed circuit board may include a conductive pattern (e.g., the conductive pattern 710 in FIG. 7) extending from the conductive region. The conductive pattern of the printed circuit board may be electrically connected to the conductive trace of the connecting member through the conductive region.

The conductive pattern may include a first pattern (e.g., the first pattern 711 in FIG. 7) extending from the conductive region and a second pattern (e.g., the second pattern 712 in FIG. 7) extending from the first pattern to the at least one ground portion.

The wearable electronic device according to one embodiment may include a first circuit element. The first pattern and the second pattern may be electrically connected through the first circuit element.

In one embodiment, the printed circuit board may include a first conductive via (e.g., the first conductive via 781 in FIG. 7). The conductive pattern may include a third pattern extending from the first pattern (e.g., the third pattern 713 in FIG. 7) and a fourth pattern extending from the third pattern to the first conductive via (e.g., the fourth pattern 714 in FIG. 7).

The wearable electronic device according to one embodiment may include a second circuit element. The third pattern and the fourth pattern may be electrically connected through the second circuit element.

In one embodiment, the fourth pattern may be formed on a first layer of the printed circuit board. The conductive pattern may include a fifth pattern (e.g., the fifth pattern 715 in FIG. 8) extending from the first conductive via on a second layer different from the first layer.

In one embodiment, the printed circuit board may include a second conductive via (e.g., the second conductive via 782 in FIG. 8) electrically connected to the first conductive via. The fourth pattern may be formed on the first layer of the printed circuit board. The conductive pattern may include a fifth pattern (e.g., the fifth pattern 715 in FIG. 8) extending from the second conductive via on a second layer different from the first layer.

In one embodiment, the fifth pattern of the conductive pattern may extend to the at least one ground portion by a first length to be electrically connected to the at least one ground portion, or extend by a length shorter than the first length to be electrically open to the at least one ground portion.

In one embodiment, the conductive pattern may include a fifth pattern (e.g., the fifth pattern 715 in FIG. 8). The fifth pattern may extend from the conductive region by a first length to be electrically connected to the at least one ground portion, or extend by a length shorter than the first length to be electrically open to the at least one ground portion.

The wearable electronic device according to one embodiment may include a bracket (e.g., the bracket 460 in FIG. 4) disposed within the frame. The printed circuit board may include a first surface (e.g., the first surface 480A in FIG. 8) and a second surface (e.g., the second surface 480B in FIG. 7) opposite the first surface and facing the bracket. The extension portion of the connecting member may be disposed between the side wall and the bracket. The first portion of the connecting member may be disposed on the first surface of the printed circuit board. The second portion of the connecting member may be disposed on a second surface of the printed circuit board.

Fig. 12 is a block diagram illustrating an electronic device 1201 in a network environment 1200 according to various embodiments. Referring to Fig. 12, the electronic device 1201 in the network environment 1200 may communicate with an electronic device 1202 via a first network 1298 (e.g., a short-range wireless communication network), or at least one of an electronic device 1204 or a server 1208 via a second network 1299 (e.g., a long-range wireless communication network). According to an embodiment, the electronic device 1201 may communicate with the electronic device 1204 via the server 1208. According to an embodiment, the electronic device 1201 may include a processor 1220, memory 1230, an input module 1250, a sound output module 1255, a display module 1260, an audio module 1270, a sensor module 1276, an interface 1277, a connecting terminal 1278, a haptic module 1279, a camera module 1280, a power management module 1288, a battery 1289, a communication module 1290, a subscriber identification module(SIM) 1296, or an antenna module 1297. In some embodiments, at least one of the components (e.g., the connecting terminal 1278) may be omitted from the electronic device 1201, or one or more other components may be added in the electronic device 1201. In some embodiments, some of the components (e.g., the sensor module 1276, the camera module 1280, or the antenna module 1297) may be implemented as a single component (e.g., the display module 1260).

The processor 1220 may execute, for example, software (e.g., a program 1240) to control at least one other component (e.g., a hardware or software component) of the electronic device 1201 coupled with the processor 1220, and may perform various data processing or computation. According to one embodiment, as at least part of the data processing or computation, the processor 1220 may store a command or data received from another component (e.g., the sensor module 1276 or the communication module 1290) in volatile memory 1232, process the command or the data stored in the volatile memory 1232, and store resulting data in non-volatile memory 1234. According to an embodiment, the processor 1220 may include a main processor 1221 (e.g., a central processing unit (CPU) or an application processor (AP)), or an auxiliary processor 1223 (e.g., a graphics processing unit (GPU), a neural processing unit (NPU), an image signal processor (ISP), a sensor hub processor, or a communication processor (CP)) that is operable independently from, or in conjunction with, the main processor 1221. For example, when the electronic device 1201 includes the main processor 1221 and the auxiliary processor 1223, the auxiliary processor 1223 may be adapted to consume less power than the main processor 1221, or to be specific to a specified function. The auxiliary processor 1223 may be implemented as separate from, or as part of the main processor 1221.

The auxiliary processor 1223 may control at least some of functions or states related to at least one component (e.g., the display module 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). According to an embodiment, the auxiliary processor 1223 (e.g., an image signal processor or a communication processor) may be implemented as part of another component (e.g., the camera module 1280 or the communication module 1290) functionally related to the auxiliary processor 1223. According to an embodiment, the auxiliary processor 1223 (e.g., the neural processing unit) may include a hardware structure specified for artificial intelligence model processing. An artificial intelligence model may be generated by machine learning. Such learning may be performed, e.g., by the electronic device 1201 where the artificial intelligence is performed or via a separate server (e.g., the server 1208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1230 may store various data used by at least one component (e.g., the processor 1220 or the sensor module 1276) of the electronic device 1201. The various data may include, for example, software (e.g., the program 1240) and input data or output data for a command related thererto. The memory 1230 may include the volatile memory 1232 or the non-volatile memory 1234.

The program 1240 may be stored in the memory 1230 as software, and may include, for example, an operating system (OS) 1242, middleware 1244, or an application 1246.

The input module 1250 may receive a command or data to be used by another component (e.g., the processor 1220) of the electronic device 1201, from the outside (e.g., a user) of the electronic device 1201. The input module 1250 may include, for example, a microphone, a mouse, a keyboard, a key (e.g., a button), or a digital pen (e.g., a stylus pen).

The sound output module 1255 may output sound signals to the outside of the electronic device 1201. The sound output module 1255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1260 may visually provide information to the outside (e.g., a user) of the electronic device 1201. The display module 1260 may include, for example, a display, a hologram device, or a projector and control circuitry to control a corresponding one of the display, hologram device, and projector. According to an embodiment, the display module 1260 may include a touch sensor adapted to detect a touch, or a pressure sensor adapted to measure the intensity of force incurred by the touch.

The audio module 1270 may convert a sound into an electrical signal and vice versa. According to an embodiment, the audio module 1270 may obtain the sound via the input module 1250, or output the sound via the sound output module 1255 or a headphone of an external electronic device (e.g., an electronic device 1202) directly (e.g., wiredly) or wirelessly coupled with the electronic device 1201.

The sensor module 1276 may detect an operational state (e.g., power or temperature) of the electronic device 1201 or an environmental state (e.g., a state of a user) external to the electronic device 1201, and then generate an electrical signal or data value corresponding to the detected state. According to an embodiment, the sensor module 1276 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device (e.g., the electronic device 1202) directly (e.g., wiredly) or wirelessly. According to an embodiment, the interface 1277 may include, for example, a high definition multimedia interface (HDMI), a universal serial bus (USB) interface, a secure digital (SD) card interface, or an audio interface.

A connecting terminal 1278 may include a connector via which the electronic device 1201 may be physically connected with the external electronic device (e.g., the electronic device 1202). According to an embodiment, the connecting terminal 1278 may include, for example, a HDMI connector, a USB connector, a SD card connector, or an audio connector (e.g., a headphone connector).

The haptic module 1279 may convert an electrical signal into a mechanical stimulus (e.g., a vibration or a movement) or electrical stimulus which may be recognized by a user via his tactile sensation or kinesthetic sensation. According to an embodiment, the haptic module 1279 may include, for example, a motor, a piezoelectric element, or an electric stimulator.

The camera module 1280 may capture a still image or moving images. According to an embodiment, the camera module 1280 may include one or more lenses, image sensors, image signal processors, or flashes.

The power management module 1288 may manage power supplied to the electronic device 1201. According to one embodiment, the power management module 1288 may be implemented as at least part of, for example, a power management integrated circuit (PMIC).

The battery 1289 may supply power to at least one component of the electronic device 1201. According to an embodiment, the battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the application processor (AP)) and supports a direct (e.g., wired) communication or a wireless communication. According to an embodiment, the communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device via the first network 1298 (e.g., a short-range communication network, such as Bluetooth^{™}, wireless-fidelity (Wi-Fi) direct, or infrared data association (IrDA)) or the second network 1299 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1292 may identify and authenticate the electronic device 1201 in a communication network, such as the first network 1298 or the second network 1299, using subscriber information (e.g., international mobile subscriber identity (IMSI)) stored in the subscriber identification module 1296.

The wireless communication module 1292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1292 may support a high-frequency band (e.g., the mmWave band) to achieve, e.g., a high data transmission rate. The wireless communication module 1292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1292 may support various requirements specified in the electronic device 1201, an external electronic device (e.g., the electronic device 1204), or a network system (e.g., the second network 1299). According to an embodiment, the wireless communication module 1292 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1297 may transmit or receive a signal or power to or from the outside (e.g., the external electronic device) of the electronic device 1201. According to an embodiment, the antenna module 1297 may include an antenna including a radiating element composed of a conductive material or a conductive pattern formed in or on a substrate (e.g., a printed circuit board (PCB)). According to an embodiment, the antenna module 1297 may include a plurality of antennas (e.g., array antennas). In such a case, at least one antenna appropriate for a communication scheme used in the communication network, such as the first network 1298 or the second network 1299, may be selected, for example, by the communication module 1290 (e.g., the wireless communication module 1292) from the plurality of antennas. The signal or the power may then be transmitted or received between the communication module 1290 and the external electronic device via the selected at least one antenna. According to an embodiment, another component (e.g., a radio frequency integrated circuit (RFIC)) other than the radiating element may be additionally formed as part of the antenna module 1297.

According to various embodiments, the antenna module 1297 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1201 and the external electronic device 1204 via the server 1208 coupled with the second network 1299. Each of the electronic devices 1202 or 1204 may be a device of a same type as, or a different type, from the electronic device 1201. According to an embodiment, all or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1201. The electronic device 1201 may provide the outcome, with or without further processing of the outcome, as at least part of a reply to the request. To that end, a cloud computing, distributed computing, mobile edge computing (MEC), or client-server computing technology may be used, for example. The electronic device 1201 may provide ultra low-latency services using, e.g., distributed computing or mobile edge computing. In another embodiment, the external electronic device 1204 may include an internet-of-things (IoT) device. The server 1208 may be an intelligent server using machine learning and/or a neural network. According to an embodiment, the external electronic device 1204 or the server 1208 may be included in the second network 1299. The electronic device 1201 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1240) including one or more instructions that are stored in a storage medium (e.g., internal memory 1236 or external memory 1238) that is readable by a machine (e.g., the electronic device 1201). For example, a processor (e.g., the processor 1220) of the machine (e.g., the electronic device 1201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A wearable electronic device comprising:
a frame forming a side wall of the wearable electronic device;
a printed circuit board disposed within the frame and including at least one ground portion; and
a connecting member at least a portion of which extends along the side wall,
wherein the connecting member includes:
an extension portion extending along the side wall;
a first portion extending from a first end of the extension portion and connected to the printed circuit board;
a second portion extending from a second end of the extension portion and connected to a conductive region of the printed circuit board; and
a conductive trace extending from the first portion to the second portion through the extension portion,
the conductive trace is electrically connected to the at least one ground portion through the conductive region of the printed circuit board, and
the printed circuit board includes a conductive pattern extending from the conductive region.

2. The wearable electronic device of claim **1,** wherein the conductive pattern includes a first pattern extending from the conductive region.

3. The wearable electronic device of claim **1,** wherein the conductive pattern includes a second pattern extending from the first pattern to the at least one ground portion.

4. The wearable electronic device of claim 3, wherein the printed circuit board includes a first circuit element, and the first pattern and the second pattern are electrically connected through the first circuit element.

5. The wearable electronic device of claim 2, wherein the conductive pattern includes a third pattern extending from the first pattern.

6. The wearable electronic device of claim 5, wherein the printed circuit board includes a first conductive via, and
the conductive pattern includes a fourth pattern extending from the third pattern to the first conductive via.

7. The wearable electronic device of claim 6, wherein the printed circuit board includes a second circuit element, and
the third pattern and the fourth pattern are electrically connected through the second circuit element.

8. The wearable electronic device of claim 6, wherein the fourth pattern is formed on a first layer of the printed circuit board.

9. The wearable electronic device of claim 8, wherein the conductive pattern includes a fifth pattern extending from the first conductive via on a second layer different from the first layer.

10. The wearable electronic device of claim 9, wherein the fifth pattern of the conductive pattern extends to the at least one ground portion by a first length to be electrically connected to the at least one ground portion, or extends by a length shorter than the first length to be electrically open to the at least one ground portion.

11. The wearable electronic device of claim 8, wherein the printed circuit board includes a second conductive via electrically connected to the first conductive via, and
the conductive pattern includes a fifth pattern extending from the second conductive via in a second layer different from the first layer.

12. The wearable electronic device of claim 11, wherein the fifth pattern of the conductive pattern extends to the at least one ground portion by a first length to be electrically connected to the at least one ground portion, or extends by a length shorter than the first length to be electrically open to the at least one ground portion.

13. The wearable electronic device of claim 1, wherein the conductive pattern includes a fifth pattern, and
the fifth pattern extends from the conductive region by a first length to be electrically connected to the at least one ground portion, or extends by a length shorter than the first length to be electrically open to the at least one ground portion.

14. The wearable electronic device of claim 1, comprising a bracket disposed within the frame,
wherein the printed circuit board includes a first surface and a second surface opposite the first surface and facing the bracket, and
the extension portion of the connecting member is disposed between the side wall and the bracket.

15. The wearable electronic device of claim 14, wherein the first portion of the connecting member is disposed on the first surface of the printed circuit board, and
the second portion of the connecting member is disposed on a second surface of the printed circuit board.
